# EUROPEAN PATENT APPLICATION

(11) **EP 4 712 748 A1**
(43) Date of publication of application: **18.03.2026**
(21) Application number: 25197359.0
(22) Date of filing: 21.08.2025
(51) Int. Cl.: H10K 59/38, H10K 59/80

(54) **DISPLAY DEVICE AND ELECTRONIC DEVICE INCLUDING THE SAME**

(30) Priority: 12.09.2024 KR 20240124824
(71) Applicant: Samsung Display Co., Ltd., Yongin-si, Gyeonggi-do 17113 (KR)
(72) Inventor: LEE, Jung-Woo, 17113 Giheung-Gu, Yongin-si, Gyeonggi-Do (KR); LAZO MARTINEZ, Israel Esteban, 17113 Giheung-Gu, Yongin-si, Gyeonggi-Do (MX); KIM, Kyeongjong, 17113 Giheung-Gu, Yongin-si, Gyeonggi-Do (KR); KIM, Su Jeong, 17113 Giheung-Gu, Yongin-si, Gyeonggi-Do (KR); KIM, Wooyoung, 17113 Giheung-Gu, Yongin-si, Gyeonggi-Do (KR); LEE, Jinhyeong, 17113 Giheung-Gu, Yongin-si, Gyeonggi-Do (KR)
(74) Representative: Dr. Weitzel & Partner

(57) **Abstract**

An anti-reflective layer (ARL) includes a light blocking pattern (BM) including a first opening (OP1) overlapping a first light emitting element (ED1), a second opening (OP2) overlapping a second light emitting element (ED2), and a third opening (OP3) overlapping a third light emitting element (ED3), a first color filter (CP1) overlapping the first opening (OP1), a second color filter (CP2) overlapping the second opening (OP2), a third color filter (CP3) overlapping the third opening (OP3), a first sub-pattern (SP1) overlapping a portion of the second color filter (CP2) and a portion of the third color filter (CP3), the first sub-pattern (SP1) and the first color filter (CP1) including a same material, a second sub-pattern (SP2) overlapping the first light emitting element (ED1) in a plan view, the second sub-pattern (SP2) and the second color filter (CP2) including a same material, and an overcoat layer (OC) covering the first, second, and third color filters (CP1-CP3) and the second sub-pattern (SP2).

## Description

The present invention relates to a display device including color filters and an electronic device with such a display device.

Display devices, such as televisions, monitors, smart phones, or tablet computers, which provide a user with images, include a display panel to display the images, an anti-reflective layer, and a window. Various types of display panels, including liquid crystal display panels, organic light emitting display panels, electrowetting display panels, and electrophoretic display panels, are being developed.

The invention provides a display device with improved display quality.

However, embodiments are not limited to those set forth herein. The above and other embodiments will become more apparent to one of ordinary skill in the art to which the invention pertains by referencing the detailed description of the invention given below.

The invention is defined by the features of the independent claims. The dependent claims and the description provide preferred embodiments.

According to an embodiment of the invention, a display device includes a display layer including a first light emitting element that emits a first color light, a second light emitting element that emits a second color light different from the first color light, and a third light emitting element that emits a third color light different from the first and second color lights, an input sensor layer disposed on the display layer and including a reflective pattern, and an anti-reflective layer disposed on the input sensor layer. The anti-reflective layer includes a light blocking pattern including a first opening overlapping the first light emitting element, a second opening overlapping the second light emitting element, and a third opening overlapping the third light emitting element, a first color filter overlapping the first opening, a second color filter overlapping the second opening, a third color filter overlapping the third opening, a first sub-pattern overlapping a portion of the second color filter and a portion of the third color filter, the first sub-pattern and the first color filter including a same material, a second sub-pattern overlapping the first light emitting element in a plan view, the second sub-pattern and the second color filter comprising a same material, and an overcoat layer covering the first, second, and third color filters and the second sub-pattern.

The first sub-pattern may be covered by the second color filter and/or the third color filter. Especially, the first sub-pattern may be covered by the second color filter and the third color filter, respectively.

The first color filter may selectively, that is exclusively (or only), transmit a blue light, the second color filter may selectively, that is exclusively (or only), transmit a red light, and the third color filter may selectively, that is exclusively (or only), transmit a green light.

The input sensor layer may include a conductive layer and an insulating layer covering the conductive layer, the reflective pattern may be electrically insulated from the conductive layer, and the reflective pattern and the conductive layer comprise a same material.

The light blocking pattern may include a black coloring agent that absorbs a light.

An area where the light blocking pattern is disposed may be defined as a light blocking area through which a light does not transmit.

An area where the first sub-pattern or the second sub-pattern is disposed may transmit less light than an area where only one of the first, second, and third color filter is disposed.

An area where the first sub-pattern or the second sub-pattern is disposed may absorb an external light.

The first color filter may include a first portion having a first height and a second portion having a second height smaller than the first height, and the second sub-pattern may overlap the second portion of the first color filter.

The second sub-pattern may be disposed on the first color filter.

The first color filter may include a color filter opening, and the second sub-pattern may be disposed in the color filter opening.

The anti-reflective layer may further include a third sub-pattern disposed on the second sub-pattern, and the third sub-pattern and the third color filter comprise a same material.

An area where two or more color filters of the first, second, and third color filters overlap each other may be defined as a light blocking area.

According to an embodiment of the invention, a display device includes a display layer including a first light emitting element that emits a first color light, a second light emitting element that emits a second color light different from the first color light, and a third light emitting element that emits a third color light different from the first and second color lights and an anti-reflective layer disposed on the display layer. The anti-reflective layer may include a light blocking pattern defining a light blocking area through which a light does not transmit, a first color filter overlapping the first light emitting element and selectively, that is exclusively (or only), transmitting a blue light, a second color filter overlapping the second light emitting element and selectively, that is exclusively (or only), transmitting a red light, and a third color filter overlapping the third light emitting element and selectively, that is exclusively (or only), transmitting a green light. A portion of the light blocking pattern adjacent to the first color filter defines a first light emitting area, a portion of the light blocking pattern adjacent to the second color filter defines a second light emitting area, a portion of the light blocking pattern adjacent to the third color filter defines a third light emitting area, and each of the first, second, and third light emitting areas may include a low transmission area and a high transmission area.

The anti-reflective layer may include a first sub-pattern overlapping a portion of the second light emitting area and a portion of the third light emitting area, the first sub-pattern and the first color filter including a same material, and a second sub-pattern overlapping a portion of the first light emitting area in a plan view, the second sub-pattern and the second color filter comprising a same material.

An area where the first sub-pattern overlaps the portion of the second light emitting area and the portion of the third light emitting area and an area where the second sub-pattern overlaps the portion of the first light emitting area may be defined as the low transmission area.

An area in the first, second, and third light emitting areas where only one of the first, second, and third color filter is disposed without overlapping the first sub-pattern and the second sub-pattern may be defined as the high transmission area.

The second sub-pattern may be disposed on the first color filter.

The first color filter may include a color filter opening, the second sub-pattern is disposed in the color filter opening, and the anti-reflective layer may further include a third sub-pattern disposed on the second sub-pattern, the third sub-pattern and the third color filter including a same material.

The first color filter may include a first portion having a first height and a second portion having a second height smaller than the first height, and the second sub-pattern may overlap the second portion of the first color filter.

Embodiments provide an electronic device for providing an image including a display device as described herein. The display device may include a display layer including a first light emitting element that emits a first color light, a second light emitting element that emits a second color light different from the first color light, and a third light emitting element that emits a third color light different from the first and second color lights, an input sensor layer disposed on the display layer and including a reflective pattern, and an anti-reflective layer disposed on the input sensor layer. The anti-reflective layer may include a light blocking pattern including a first opening overlapping the first light emitting element, a second opening overlapping the second light emitting element, and a third opening overlapping the third light emitting element, a first color filter overlapping the first opening, a second color filter overlapping the second opening, a third color filter overlapping the third opening, a first sub-pattern overlapping a portion of the second color filter and a portion of the third color filter, the first sub-pattern and the first color filter including a same material, a second sub-pattern overlapping the first light emitting element in a plan view, the second sub-pattern and the second color filter including a same material, and an overcoat layer covering the first, second, and third color filters and the second sub-pattern.

According to the above, the area where the first color filter overlaps the second sub-pattern and/or the third sub-pattern and the area where the second color filter and/or the third color filter overlaps the first sub-pattern are defined as the low transmission area or the light blocking area. The low transmission area or the light blocking area absorb the external light. Thus, the display device, which includes the first, second, and/or third sub-patterns overlapping the first, second, and third color filters, exhibits reduced external light reflectance and improved reflective color tone in the first, second, and third light emitting areas. Accordingly, the display quality of the display device is improved.

The above and other advantages of the invention will become readily apparent by reference to the following detailed description when considered in conjunction with the accompanying drawings wherein:
FIG. 1 is a schematic perspective view of a display device according to an embodiment;
FIG. 2 is a schematic cross-sectional view showing a display device according to an embodiment;
FIG. 3 is a schematic cross-sectional view of a display panel according to an embodiment;
FIG. 4 is a schematic plan view of a portion of a display area according to an embodiment;
FIG. 5 is a schematic cross-sectional view of a display device taken along line I-I' of FIG. 4;
FIG. 6 is a schematic cross-sectional view of a display device taken along line I-I' of FIG. 4;
FIG. 7 is a schematic cross-sectional view of a display device taken along line I-I' of FIG. 4;
FIG. 8 is a schematic cross-sectional view of a display device taken along line I-I' of FIG. 4; and
FIG. 9 is a block diagram of an electronic device according to an embodiment.

In the following description, for the purposes of explanation, numerous specific details are set forth in order to provide a thorough understanding of various embodiments or implementations of the invention. As used herein, "embodiments" and "implementations" are interchangeable words that are non-limiting examples of devices or methods disclosed herein. It is apparent, however, that various embodiments may be practiced without these specific details. Here, various embodiments do not have to be exclusive nor limit the invention. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element or a layer is referred to as being "on,'' "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the axis of the first direction DR1, the axis of the second direction DR2, and the axis of the third direction DR3 are not limited to three axes of a rectangular coordinate system, such as the X, Y, and Z - axes, and may be interpreted in a broader sense. For example, the axis of the first direction DR1, the axis of the second direction DR2, and the axis of the third direction DR3 may be perpendicular to one another, or may represent different directions that are not perpendicular to one another. For the purposes of this disclosure, "at least one of A and B" may be understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the invention.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art. For example, "about" may mean within one or more standard deviations, or within ±20%, ±10%, or ±5% of the stated value.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

Hereinafter, embodiments will be described with reference to accompanying drawings.

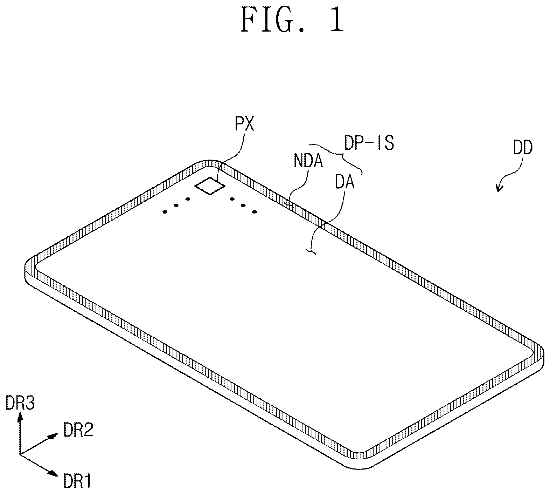

FIG. 1 is a schematic perspective view of a display device DD according to an embodiment.

The display device DD may be applied to a large-sized electronic device, such as a television set, a monitor, an outdoor billboard, etc. For example, the display device DD may be applied to a small and medium-sized electronic device, such as a personal computer, a notebook computer, a personal digital assistant, a car navigation unit, a game unit, a smart phone, a tablet computer, a camera, etc. However, these are examples, and the display device DD may be applied to other electronic devices as long as they do not depart from the concept of the invention.

Referring to FIG. 1, the display device DD may display an image through a display surface DP-IS, which is substantially parallel to a plane defined by a first direction DR1 and a second direction DR2, toward a third direction DR3. The image may include a still image as well as a video. The display surface DP-IS through which the image is displayed may correspond to a front surface of the display device DD.

In an embodiment, front (or upper) and rear (or lower) surfaces of each member of the display device DD may be defined with respect to a direction in which the image is displayed. The front and rear surfaces may be opposite to each other in the third direction DR3, and a normal line direction of each of the front and rear surfaces may be substantially parallel to the third direction DR3. Directions indicated by the first, second, and third directions DR1, DR2, and DR3 may be relative to each other, and thus, the directions indicated by the first, second, and third directions DR1, DR2, and DR3 may be changed to other directions. In the following descriptions, the expression "in a plan view" means a state of being viewed in the third direction DR3.

The display device DD may include a display area DA and a non-display area NDA adjacent to the display area DA. Pixels PX may be arranged in the display area DA and may not be arranged in the non-display area NDA. The non-display area NDA may be defined along an edge portion of the display surface DP-IS. The non-display area NDA may surround the display area DA, however, this is an example. According to an embodiment, the non-display area NDA may be omitted or may be defined adjacent to a side (or single side) of the display area DA. FIG. 1 shows the display device DD that has a flat shape as a representative example, however, embodiments are not limited thereto or thereby. As an example, the display device DD may be a curved display device.

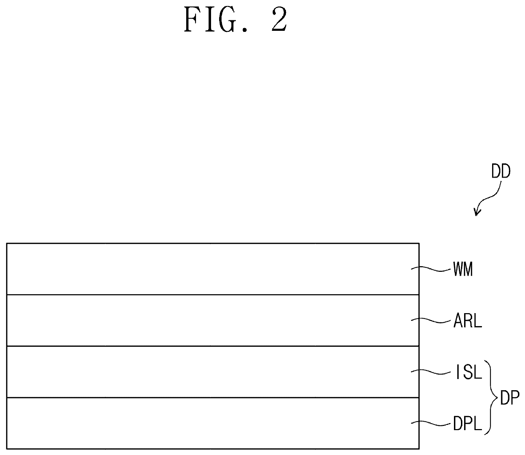

FIG. 2 is a schematic cross-sectional view showing the display device DD according to an embodiment.

Referring to FIG. 2, the display device DD may include a display panel DP, an anti-reflective layer ARL, and a window WM. The display panel DP may include a display layer DPL and an input sensor layer ISL.

The display layer DPL may be a light emitting type display layer. For example, the display layer DPL may be an organic light emitting display layer, an inorganic light emitting display layer, an organic-inorganic light emitting display layer, a micro-LED display layer, or a nano-LED display layer.

The input sensor layer ISL may be disposed on the display layer DPL. The input sensor layer ISL may sense an external input applied thereto from the outside. The external input may be a user's input. The user's input may include a variety of external inputs, such as a part of user's body, light, heat, pen, or pressure.

The input sensor layer ISL may be formed on the display layer DPL through successive processes. For example, the input sensor layer ISL may be disposed (e.g., directly disposed) on the display layer DPL. In the disclosure, the expression "A component A is disposed directly on a component B." means that no intervening elements are present between the component A and the component B. For example, an adhesive member may not be disposed between the input sensor layer ISL and the display layer DPL.

The anti-reflective layer ARL may be disposed on the input sensor layer ISL. The anti-reflective layer ARL may reduce a reflectance of the display device DD with respect to an external light. The anti-reflective layer ARL may be disposed (e.g., directly disposed) on the input sensor layer ISL through successive processes.

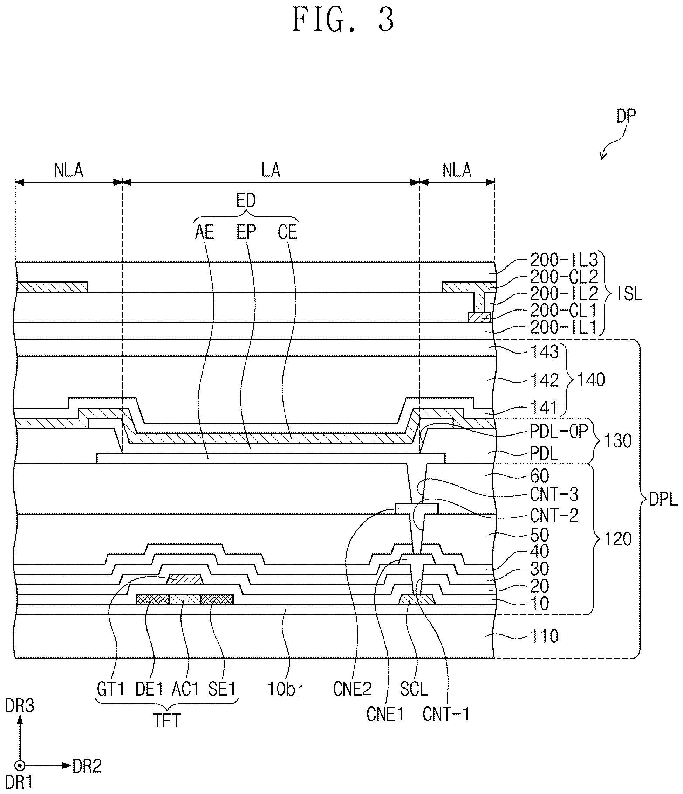

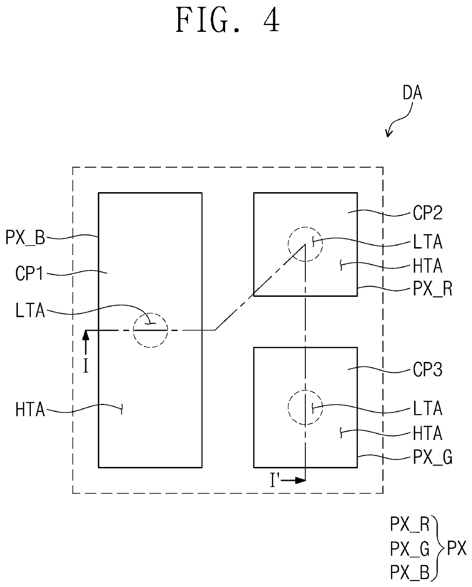

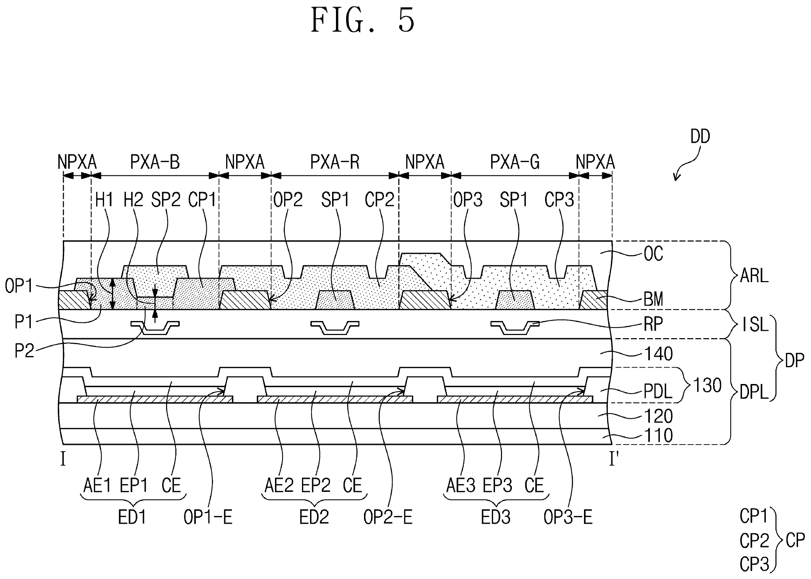

The anti-reflective layer ARL may include a color filter CP (refer to FIG. 5) overlapping a light emitting area described later. The color filter CP may include color filters CP1, CP2, and CP3(refer to FIG. 4). According to an embodiment, the anti-reflective layer ARL may further include a light blocking pattern BM (refer to FIG. 5). The light blocking pattern BM may overlap a non-light-emitting area NLA (refer to FIG. 3) of the display layer DPL. According to an embodiment, the light blocking pattern BM may overlap a reflective structure, e.g., a second conductive layer 200-CL2, disposed under the anti-reflective layer ARL. Detailed descriptions of the anti-reflective layer ARL will be described later. According to the invention, since the display device DD includes the color filter CP1, CP2, or CP3 and the light blocking pattern BM instead of a polarizing plate, a thickness of the display device DD may be reduced, and a light emitting efficiency of the display device DD may be improved.

The window WM may be disposed on the anti-reflective layer ARL. The window WM and the anti-reflective layer ARL may be coupled to each other by an adhesive layer. The adhesive layer may be a pressure sensitive adhesive (PSA) film or an optically clear adhesive (OCA).

The window WM may include at least one base layer. The base layer may be a glass substrate or a synthetic resin film. The window WM may have a multi-layer structure. The window WM may include a thin film glass substrate and a synthetic resin film disposed on the thin film glass substrate. The thin film glass substrate and the synthetic resin film may be coupled to each other by an adhesive layer, and the adhesive layer and the synthetic resin film may be separated from the thin film glass substrate to be replaced.

According to an embodiment, the adhesive layer may be omitted, and the window WM may be disposed (e.g., directly disposed) on the anti-reflective layer ARL. An organic material, an inorganic material, or a ceramic material may be coated on the anti-reflective layer ARL.

FIG. 3 is a schematic cross-sectional view of the display panel DP according to an embodiment.

FIG. 3 shows a cross-section corresponding to a light emitting area (e.g., single light emitting area) LA and the non-light-emitting area NLA around the light emitting area LA. FIG. 3 shows only one light emitting area LA, however, the light emitting area LA may be provided in plural. FIG. 3 shows a light emitting element ED and a transistor TFT connected to the light emitting element ED. The transistor TFT may be one of transistors included in a driving circuit of the pixels PX (refer to FIG. 1). In an embodiment, the transistor TFT will be described as a silicon transistor, however, according to an embodiment, the transistor TFT may be a metal oxide transistor.

Referring to FIG. 3, the display panel DP may include the display layer DPL and the input sensor layer ISL. The display layer DPL may include a base layer 110, a circuit layer 120, a light emitting element layer 130, and a thin film encapsulation layer 140.

The base layer 110 may provide a base surface on which the circuit layer 120 is disposed. The base layer 110 may be a rigid substrate or a flexible substrate that is bendable, foldable, or rollable. The base layer 110 may be a glass substrate, a metal substrate, or a polymer substrate, however, embodiments are not limited thereto or thereby. According to an embodiment, the base layer 110 may be an inorganic layer, an organic layer, or a composite material layer.

The base layer 110 may have a multi-layer structure. For instance, the base layer 110 may include a first synthetic resin layer, an inorganic layer having a single-layer structure or a multi-layer structure, and a second synthetic resin layer disposed on the inorganic layer having the single-layer structure or the multi-layer structure. Each of the first and second synthetic resin layers may include a polyimide-based resin, however, embodiments are not limited thereto.

The circuit layer 120 may be disposed on the base layer 110. The circuit layer 120 may include an insulating layer, a semiconductor pattern, a conductive pattern, a signal line, and the driving circuit of the pixels PX. As an example, the circuit layer 120 may include a buffer layer 10br, first, second, third, fourth, fifth and sixth insulating layers 10, 20, 30, 40, 50 and 60, a signal transmission area SCL, and connection electrodes CNE1 and CNE2.

The buffer layer 10br may be disposed on the base layer 110. The buffer layer 10br may prevent metal atoms or impurities from being diffused to the semiconductor pattern disposed thereon from the base layer 110. The semiconductor pattern may include an active area AC1 of the transistor TFT. A rear surface metal layer may be further disposed between the base layer 110 and the buffer layer 10br. The rear surface metal layer may be disposed under the transistor TFT, and the rear surface metal layer may prevent the external light from reaching the transistor TFT.

The semiconductor pattern may be disposed on the buffer layer 10br. The semiconductor pattern may include a silicon semiconductor. As an example, the silicon semiconductor may include amorphous silicon or polycrystalline silicon. For example, the semiconductor pattern may include low temperature polycrystalline silicon.

The semiconductor pattern may include a first region having a relatively high conductivity and a second region having a relatively low conductivity. The first region may be doped with an N-type dopant or a P-type dopant. A P-type transistor may include a doped region doped with the P-type dopant, and an N-type transistor may include a doped region doped with the N-type dopant. The second region may be a non-doped region or a region doped at a concentration lower than that of the first region.

The first region may have a conductivity greater than that of the second region and may substantially function as an electrode or a signal line. The second region may substantially correspond to an active area (or a channel) of the transistor. For example, a portion of the semiconductor pattern may be the active area of the transistor, another portion of the semiconductor pattern may be a source or a drain of the transistor, and the other portion of the semiconductor pattern may be a connection electrode or a connection signal line.

The transistor TFT may include a source area SE1 (or a source), the active area AC1 (or a channel), a drain area DE1 (or a drain), and a gate GT1. The source area SE1, the active area AC1, and the drain area DE1 of the transistor TFT may be formed using the semiconductor pattern. The source area SE1 and the drain area DE1 of the transistor TFT may extend in opposite directions to each other from the active area AC1 in a cross-section. FIG. 3 shows a portion of the signal transmission area SCL formed using the semiconductor pattern. For example, the signal transmission area SCL may be connected to the drain area DE1 of the transistor TFT in a plan view.

The first insulating layer 10 may be disposed on the buffer layer 10br. The first insulating layer 10 may cover the source area SE1, the active area AC1, the drain area DE1, and the signal transmission area SCL of the transistor TFT disposed on the buffer layer 10br.

The first insulating layer 10 may include an inorganic layer and/or an organic layer and may have a single-layer structure or a multi-layer structure. The inorganic layer may include at least one of aluminum oxide, titanium oxide, silicon oxide, silicon nitride, silicon oxynitride, zirconium oxide, and hafnium oxide. In an embodiment, the first insulating layer 10 may have a single-layer structure of a silicon oxide layer. Other insulating layers of the circuit layer 120 described later may be an inorganic layer and/or an organic layer and may have a single-layer structure or a multi-layer structure as well as the first insulating layer 10. The inorganic layer may include at least one of the above-mentioned materials, however, embodiments are not limited thereto or thereby.

The gate GT1 of the transistor TFT may be disposed on the first insulating layer 10. The gate GT1 may be a portion of a metal pattern. The gate GT1 may overlap the active area AC1. The gate GT1 may be used as a mask in a process of doping the semiconductor pattern. The gate GT1 may include titanium (Ti), silver (Ag), an alloy including silver (Ag), molybdenum (Mo), an alloy including molybdenum (Mo), aluminum (Al), an alloy including aluminum (Al), aluminum nitride (AlN), tungsten (W), tungsten nitride (WN), copper (Cu), indium tin oxide (ITO), indium zinc oxide (IZO), or the like, however, embodiments are not limited thereto.

The second insulating layer 20 may be disposed on the first insulating layer 10 and may cover the gate GT1. The third insulating layer 30 may be disposed on the second insulating layer 20.

A first connection electrode CNE1 may be disposed on the third insulating layer 30. The first connection electrode CNE1 may be connected to the signal transmission area SCL via a contact hole CNT-1 defined (or formed) through the first, second, and third insulating layers 10, 20, and 30. The fourth insulating layer 40 may be disposed on the third insulating layer 30 and may cover the first connection electrode CNE1. The fourth insulating layer 40 may be an organic layer.

The fifth insulating layer 50 may be disposed on the fourth insulating layer 40. A second connection electrode CNE2 may be disposed on the fifth insulating layer 50. The second connection electrode CNE2 may be connected to the first connection electrode CNE1 via a contact hole CNT-2 defined (or formed) through the fourth insulating layer 40 and the fifth insulating layer 50. The fifth insulating layer 50 may be an organic layer.

A sixth insulating layer 60 may be disposed on the fifth insulating layer 50 and may cover the second connection electrode CNE2. The sixth insulating layer 60 may be an organic layer. The stack structure of the first to sixth insulating layers 10 to 60 is an example, and additional conductive layer and insulating layer may be disposed in addition to the first to sixth insulating layers 10 to 60.

The light emitting element layer 130 may be disposed on the circuit layer 120. The light emitting element layer 130 may include the light emitting element ED, and a pixel definition layer PDL.

The light emitting element ED may include an organic light emitting element, an inorganic light emitting element, an organic-inorganic light emitting element, a quantum dot light emitting element, a micro-LED, or a nano-LED, however, the light emitting element ED should not be particularly limited. The light emitting element ED may include various embodiments as long as it generates a light or control the amount of light in response to an electrical signal.

The light emitting element ED may include a first electrode (or anode) AE, a light emitting pattern EP, and a second electrode (or cathode) CE. The first electrode AE may be disposed on the sixth insulating layer 60. The first electrode AE may be connected to the second connection electrode CNE2 via a contact hole CNT-3 defined (or formed) through the sixth insulating layer 60. The first electrode AE may be a transmissive electrode, a semi-transmissive electrode, or a reflective electrode. The first electrode AE may include a reflective layer formed of Ag, Mg, Al, Pt, Pd, Au, Ni, Nd, Ir, Cr, or compounds thereof and a transparent electrode layer or a semi-transparent electrode layer formed on the reflective layer. The transparent electrode layer or the semi-transparent electrode layer may include at least one selected from the group consisting of indium tin oxide (ITO), indium zinc oxide (IZO), indium gallium zinc oxide (IGZO), zinc oxide (ZnO), indium oxide (In₂O₃), and aluminum-doped zinc oxide (AZO). For instance, the first electrode AE may have a stack structure of ITO/Ag/ITO.

The pixel definition layer PDL may be disposed on the sixth insulating layer 60. The pixel definition layer PDL may have a light absorbing property. For example, the pixel definition layer PDL may have a black color. The pixel definition layer PDL may include a black coloring agent. The black coloring agent may include a black dye or a black pigment. The black coloring agent may include a metal material, such as carbon black, chromium, or an oxide thereof. The pixel definition layer PDL may correspond to the light blocking pattern BM having a light blocking property.

The pixel definition layer PDL may cover a portion of the first electrode AE. As an example, an opening PDL-OP may be defined (or formed) through the pixel definition layer PDL to expose a portion of the first electrode AE. The opening PDL-OP of the pixel definition layer PDL may define the light emitting area LA.

For example, a hole control layer may be further disposed between the first electrode AE and the light emitting pattern EP. The hole control layer may include a hole transport layer and/or a hole injection layer. An electron control layer may be disposed between the light emitting pattern EP and the second electrode CE. The electron control layer may further include an electron transport layer and/or an electron injection layer.

The light emitting element layer 130 may further include a capping layer. The capping layer may be disposed on the light emitting element ED and may cover the second electrode CE of the light emitting element ED. The capping layer may include an organic material. The capping layer may have a single-layer structure or a multi-layer structure. The capping layer may protect the second electrode CE and an organic light emitting layer disposed thereunder from moisture or contaminants from the outside, and thus, a lifespan of the light emitting element ED may be improved.

The thin film encapsulation layer 140 may be disposed on the light emitting element layer 130. The thin film encapsulation layer 140 may protect the light emitting element layer 130 from moisture, oxygen, and a foreign substance such as dust particles. The thin film encapsulation layer 140 may include a first inorganic layer 141, an organic layer 142, and a second inorganic layer 143, which are sequentially stacked, however, layers forming the thin film encapsulation layer 140 should not be limited thereto or thereby.

The first and second inorganic layers 141 and 143 may protect the light emitting element layer 130 from moisture and oxygen, and the organic layer 142 may protect the light emitting element layer 130 from the foreign substance such as dust particles. The first and second inorganic layers 141 and 143 may include a silicon nitride layer, a silicon oxynitride layer, a silicon oxide layer, a titanium oxide layer, or an aluminum oxide layer. The organic layer 142 may include an acrylic-based organic layer, however, embodiments are not limited thereto.

The input sensor layer ISL may be disposed on the display layer DPL. The input sensor layer ISL may be referred to as a sensor layer, an input sensing layer, or an input sensing panel. The input sensor layer ISL may include a base insulating layer 200-IL1, a first conductive layer 200-CL1, a sensing insulating layer 200-IL2, a second conductive layer 200-CL2, and a cover layer 200-IL3.

The base insulating layer 200-IL1 may be disposed (e.g., directly disposed) on the display layer DPL. The base insulating layer 200-IL1 may be an inorganic layer including at least one of silicon nitride, silicon oxynitride, and silicon oxide. According to an embodiment, the base insulating layer 200-IL1 may be an organic layer including an epoxy resin, an acrylic resin, or an imide-based resin. The base insulating layer 200-IL1 may have a single-layer structure or a multi-layer structure of layers stacked in the third direction DR3.

Each of the first conductive layer 200-CL1 and the second conductive layer 200-CL2 may have a single-layer structure or a multi-layer structure of layers stacked in the third direction DR3. Each of the first conductive layer 200-CL1 and the second conductive layer 200-CL2 may include a sensing pattern, which has a mesh structure, or a bridge pattern.

The conductive layer having the single-layer structure may include a metal layer or a transparent conductive layer. The metal layer may include molybdenum, silver, titanium, copper, aluminum, or alloys thereof. The transparent conductive layer may include a transparent conductive oxide, such as indium tin oxide (ITO), indium zinc oxide (IZO), indium zinc tin oxide (IZTO), or the like. For example, the transparent conductive layer may include conductive polymer such as PEDOT, metal nanowire, graphene, or the like.

The conductive layer having the multi-layer structure may include metal layers. The metal layers may have a three-layer structure of titanium/aluminum/titanium. The conductive layer having the multi-layer structure may include at least one metal layer and at least one transparent conductive layer.

The sensing insulating layer 200-IL2 may be disposed between the first conductive layer 200-CL1 and the second conductive layer 200-CL2. The cover layer 200-IL3 may be disposed on the sensing insulating layer 200-IL2 and may cover the second conductive layer 200-CL2. The cover layer 200-IL3 may reduce or remove a probability of damage to the second conductive layer 200-CL2 in a subsequent process. According to an embodiment, the input sensor layer ISL may not include the cover layer 200-IL3.

The sensing insulating layer 200-IL2 and the cover layer 200-IL3 may include an inorganic layer. The inorganic layer may include at least one of aluminum oxide, titanium oxide, silicon oxide, silicon nitride, silicon oxynitride, zirconium oxide, and hafnium oxide.

According to an embodiment, the sensing insulating layer 200-IL2 and the cover layer 200-IL3 may include an organic layer. The organic layer may include at least one of an epoxy-based resin, a urethane-based resin, a cellulose-based resin, a siloxane-based resin, a polyimide-based resin, a polyamide-based resin, and a perylene-based resin.

FIG. 4 is a schematic plan view of a portion of the display area DA according to an embodiment. FIG. 4 is an enlarged schematic plan view of one pixel PX among the pixels PX.

Referring to FIG. 4, each of the pixels PX may include sub-pixels PX_B, PX_R, and PX_G. As an example, one pixel PX may include a first sub-pixel PX_B, a second sub-pixel PX _R, and a third sub-pixel PX_G. The first sub-pixel PX_B, the second sub-pixel PX_R, and the third sub-pixel PX_G may emit lights having different colors. As an example, the first sub-pixel PX_B may emit a blue light, the second sub-pixel PX_R may emit a red light, and the third sub-pixel PX_G may emit a green light, however, embodiments are not limited thereto or thereby.

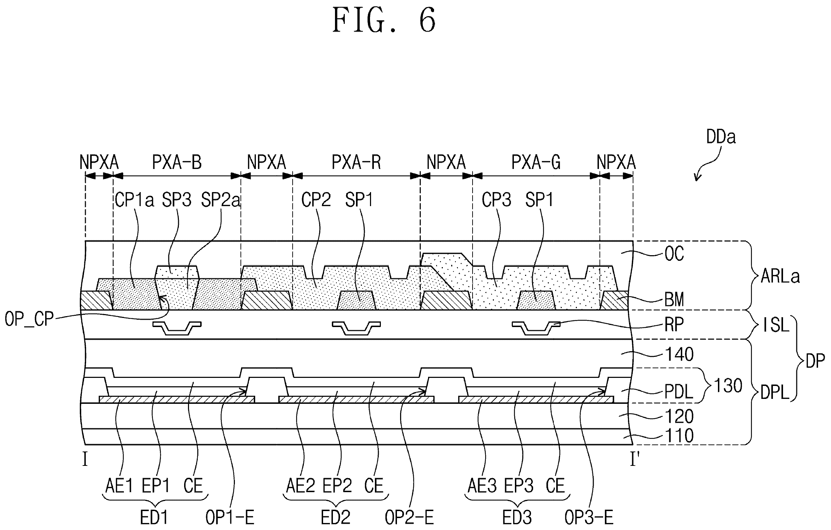

Each of the first sub-pixel PX_B, the second sub-pixel PX_R, and the third sub-pixel PX_G may include a low transmission area LTA and a high transmission area HTA. The low transmission area LTA may be an area where sub-patterns SP1, SP2, or SP3 (refer to FIGS. 5 and 6) are arranged. The high transmission area HTA may be an area where only color filters CP1, CP2, or CP3 (refer to FIG. 5) are arranged without arranging the sub-patterns SP1, SP2, or SP3. In an embodiment, a structure in which the high transmission area HTA surrounds the low transmission area LTA having a circular shape is illustrated as a representative example, however, the shape and arrangement of the low transmission area LTA and the high transmission area HTA should not be limited thereto or thereby.

FIG. 5 is a schematic cross-sectional view of the display device DD taken along line I-I' of FIG. 4. In FIG. 5, the same reference numerals denote the same elements in FIG. 3, and thus, detailed descriptions of the same elements will be omitted for descriptive convenience. For the convenience of explanation, FIG. 5 illustrates the display device DD from which the window WM (refer to FIG. 2) is omitted. Descriptions of first, second, and third light emitting elements ED1, ED2, and ED3 of FIG. 5 may be substantially the same as that of the light emitting element ED of FIG. 3.

Referring to FIG. 5, the display panel DP may include the first, second, and third light emitting elements ED1, ED2, and ED3. The first light emitting element ED1 may include a first anode AE1, a first light emitting pattern EP1, and a portion of the cathode CE. The second light emitting element ED2 may include a second anode AE2, a second light emitting pattern EP2, and a portion of the cathode CE. The third light emitting element ED3 may include a third anode AE3, a third light emitting pattern EP3, and a portion of the cathode CE.

The first, second, and third anodes AE1, AE2, and AE3 may be provided as patterns. The pixel definition layer PDL may be provided with first, second, and third light emitting openings OP1-E, OP2-E, and OP3-E defined therethrough. At least a portion of the first anode AE1 may be exposed through the first light emitting opening OP1-E. At least a portion of the second anode AE2 may be exposed through the second light emitting opening OP2-E. At least a portion of the third light emitting opening OP3-E may be exposed through the third anode AE3.

The first, second, and third light emitting patterns EP1, EP2, and EP3 may be disposed on the first, second, and third anodes AE1, AE2, and AE3, repectively. The first, second, and third light emitting patterns EP1, EP2, and EP3 may be disposed in the first, second, and third light emitting openings OP1-E, OP2-E, and OP3-E, respectively. As an example, the first light emitting pattern EP1 may be disposed in the first light emitting opening OP1-E, the second light emitting pattern EP2 may be disposed in the second light emitting opening OP2-E, and the third light emitting pattern EP3 may be disposed in the third light emitting opening OP3-E. The cathode CE may be disposed on the first, second, and third light emitting patterns EP1, EP2, and EP3 and the pixel definition layer PDL.

FIGS. 3 and 5 illustrate the structure in which the first, second, and third light emitting patterns EP1, EP2, and EP3 are disposed on the first, second, and third anodes AE1, AE2, and AE3 and the pixel definition layer PDL, however, embodiments are not limited thereto or thereby. As an example, the first, second, and third light emitting patterns EP1, EP2, and EP3 may be disposed only on the first, second, and third anodes AE1, AE2, and AE3, respectively.

The first, second, and third light emitting patterns EP1, EP2, and EP3 may emit lights having different colors from each other. As an example, the first light emitting pattern EP1 may emit a first color light, the second light emitting pattern EP2 may emit a second color light different from the first color light, and the third light emitting pattern EP3 may emit a third color light different from the first and second color lights. According to an embodiment, the first color light may be a blue light, the second color may be a red light, and the third color may be a green light.

The input sensor layer ISL may be disposed on the display layer DPL. The input sensor layer ISL may include the conductive layer (e.g., the first conductive layer 200-CL1 or the second conductive layer 200-CL2, refer to FIG. 3) and the insulating layer (e.g., the base insulating layer 200-IL1, the sensing insulating layer 200-IL2, or the cover layer 200-IL3, refer to FIG. 3) covering the conductive layer (e.g., the first conductive layer 200-CL1 or the second conductive layer 200-CL2). For example, the input sensor layer ISL may further include a reflective pattern RP.

The reflective pattern RP may reflect a portion of the lights emitted from the light emitting elements ED1, ED2, and ED3. As an example, the portion of the lights emitted from the light emitting elements ED1, ED2, and ED3 may be reflected by the reflective pattern RP, and then, may be emitted to the outside after being reflected by components disposed under the reflective pattern RP, e.g., the cathode CE. As the input sensor layer ISL includes the reflective pattern RP, the reflectance of the display panel DP may be reduced.

The reflective pattern RP and the conductive layer (e.g., the first conductive layer 200-CL1 or the second conductive layer 200-CL2) may include the same material and be formed through the same process. The reflective pattern RP may not be electrically connected to the conductive layer (e.g., the first conductive layer 200-CL1 or the second conductive layer 200-CL2). According to an embodiment, the reflective pattern RP may be formed in the input sensor layer ISL and may not be exposed to the outside of the input sensor layer ISL. For example, the reflective pattern RP may be covered by the insulating layer (e.g., the layer base insulating layer 200-IL1, the sensing insulating layer 200-IL2, or the cover layer 200-IL3), however, this is an example, and embodiments are not limited thereto or thereby. According to an embodiment, the reflective pattern RP may be exposed to the outside of the input sensor layer ISL, and the exposed reflective pattern RP may be covered by the color filters CP1, CP2, and CP3.

The anti-reflective layer ARL may be disposed on the input sensor layer ISL. The anti-reflective layer ARL may include the light blocking pattern BM, the color filters CP1, CP2, and CP3, the sub-patterns SP1 and SP2, and an overcoat layer OC.

The light blocking pattern BM may be disposed on the input sensor layer ISL. The light blocking pattern BM may be a layer having a black color and may include a black coloring agent. The black coloring agent may include a black dye or a black pigment. The black coloring agent may include a metal material, such as carbon black, chromium, or an oxide thereof. However, this is an example, and materials for the light blocking pattern BM should not be particularly limited as long as the materials absorb lights.

The light blocking pattern BM may prevent the external light from being reflected by the first conductive layer 200-CL1 and the second conductive layer 200-CL2. An area in which the light blocking pattern BM is disposed may be defined as a light blocking area through which the light does not transmit. The light blocking pattern BM may overlap the pixel definition layer PDL. The light blocking pattern BM may be provided with a first opening OP1, a second opening OP2, and a third opening OP3. The first, second, and third openings OP1, OP2, and OP3 of the light blocking pattern BM may overlap the first, second, and third light emitting openings OP1-E, OP2-E, and OP3-E of the pixel definition layer PDL, respectively. As an example, the first opening OP1 may overlap the first light emitting opening OP1-E, the second opening OP2 may overlap the second light emitting opening OP2-E, and the third opening OP3 may overlap the third light emitting opening OP3-E. For example, the first opening OP1 may overlap the first light emitting element ED1, the second opening OP2 may overlap the second light emitting element ED2, and the third opening OP3 may overlap the third light emitting element ED3.

The first, second, and third openings OP1, OP2, and OP3 of the light blocking pattern BM may define first, second, and third light emitting areas PXA-B, PXA-R, and PXA-G. The first, second, and third light emitting areas PXA-B, PXA-R, and PXA-G may respectively correspond to areas from which the lights provided from the first, second, and third light emitting elements ED1, ED2, and ED3 are emitted to the outside. For example, the first, second, and third light emitting areas PXA-B, PXA-R, and PXA-G may respectively correspond to areas from which the lights provided from the first, second, and third light emitting elements ED1, ED2, and ED3 are emitted to the outside after passing through the first, second, and third color filters CP1, CP2, and CP3.

The first, second, and third color filters CP1, CP2, and CP3 may correspond to the first, second, and third light emitting elements ED1, ED2, and ED3, respectively, may transmit the lights generated by the first, second, and third light emitting elements ED1, ED2, and ED3, respectively, and may block a light in certain wavelength ranges of the external light. The first color filter CP1 may transmit the first color light, the second color filter CP2 may transmit the second color light different from the first color light, and the third color filter CP3 may transmit the third color light different from the first and second color lights. As an example, the first color filter CP1 may selectively transmit the blue light, the second color filter CP2 may selectively transmit the red light, and the third color filter CP3 may selectively transmit the green light.

The first color filter CP1 may be disposed to overlap the first opening OP1 and may selectively transmit a portion of the light emitted from the first light emitting element ED1. The first color filter CP1 may include a first portion P1 having a first height H1 and a second portion P2 having a second height H2 smaller than the first height H1. The step difference of the first color filter CP1 may be formed using a halftone mask, however, this is an example, and embodiments are not limited thereto or thereby.

The second color filter CP2 may be disposed to overlap the second opening OP2 and may selectively transmit a portion of the light emitted from the second light emitting element ED2. The third color filter CP3 may be disposed to overlap the third opening OP3 and may selectively transmit a portion of the light emitted from the third light emitting element ED3.

The first sub-pattern SP1 and the first color filter CP1 may include the same material and may be formed through the same process. The first sub-pattern SP1 may be formed in the second light emitting area PXA-R and the third light emitting area PXA-G. The first sub-pattern SP1 may overlap a portion of the second color filter CP2 and a portion of the third color filter CP3. In case that the second and third color filters CP2 and CP3 are formed after the first color filter CP1 and the first sub-pattern SP1 are formed, the first sub-pattern SP1 may be covered by the second color filter CP2 or the third color filter CP3.

The second sub-pattern SP2 and the second color filter CP2 may include the same material and may be formed through the same process. The second sub-pattern SP2 may be formed in the first light emitting area PXA-B. The second sub-pattern SP2 may overlap the first light emitting element ED1 in a plan view. The second sub-pattern SP2 may overlap a portion of the first color filter CP1. As an example, the second sub-pattern SP2 may overlap the second portion P2 of the first color filter CP1. Since the second color filter CP2 and the second sub-pattern SP2 are formed after the first color filter CP1 and the first sub-pattern SP1 are formed, the second sub-pattern SP2 may be disposed on the first color filter CP1.

Each of the first, second, and third light emitting areas PXA-B, PXA-R, and PXA-G may include the low transmission area and the high transmission area. The area where the first sub-pattern SP1 overlaps the portion of the second light emitting area PXA-R and the portion of the third light emitting area PXA-G and the area where the second sub-pattern SP2 overlaps the portion of the first light emitting area PXA-B may be defined as the low transmission area. In the first, second, and third light emitting areas PXA-B, PXA-R, and PXA-G, the area where only one of the first, second, and third color filters CP1, CP2, and CP3 is disposed without overlapping the first sub-pattern SP1 and the second sub-pattern SP2 may be defined as the high transmission area.

The area where the first sub-pattern SP1 or the second sub-pattern SP2 is disposed may transmit less light than the area where only one of the first, second, and third color filters CP1, CP2, and CP3 is disposed. As an example, the light emitted from the second light emitting element ED2 may not transmit through the area where the first sub-pattern SP1 transmitting the blue light overlaps the second color filter CP2 transmitting the red light. As a result, the area where the first sub-pattern SP1 is disposed in the second light emitting area PXA-R may transmit less light than the area where only the second color filter CP2 is disposed in the second light emitting area PXA-R. For example, the light emitted from the third light emitting element ED3 may not transmit through the area where the first sub-pattern SP1 transmitting the blue light overlaps the third color filter CP3 transmitting the green light. As a result, the area where the first sub-pattern SP1 is disposed in the third light emitting area PXA-G may transmit less light than the area where only the third color filter CP3 is disposed in the third light emitting area PXA-G. Further, the light emitted from the first light emitting element ED1 may not transmit through the area where the second sub-pattern SP2 transmitting the red light overlaps the first color filter CP1 transmitting the blue light. As a result, the area where the second sub-pattern SP2 is disposed in the first light emitting area PXA-B may transmit less light than the area where only the first color filter CP1 is disposed in the first light emitting area PXA-B. The area where the first sub-pattern SP1 or the second sub-pattern SP2 is disposed may absorb the external light.

The overcoat layer OC may cover the first, second, and third color filters CP1, CP2, and CP3 and the second sub-pattern SP2.

FIG. 6 is a schematic cross-sectional view of a display device DDa taken along line I-I' of FIG. 4. In FIG. 6, the same reference numerals denote the same elements in FIG. 5, and thus, detailed descriptions of the same elements will be omitted for descriptive convenience. For the convenience of explanation, FIG. 6 illustrates the display device DDa from which the window WM (refer to FIG. 2) is omitted.

Referring to FIG. 6, the display device DDa may include a display panel DP and an anti-reflective layer ARLa. The anti-reflective layer ARLa may include a light blocking pattern BM, first, second, and third color filters CP1a, CP2, and CP3, first and second sub-patterns SP1 and SP2a, and SP3, and an overcoat layer OC. The sub-patterns SP1 and SP2a, and SP3 of FIG. 6 may further include a third sub-pattern SP3 compared to the sub-patterns SP1 and SP2 of FIG. 5.

First, second, and third color filters CP1a, CP2, and CP3 may include the same material and may have the same functions as the first, second, and third color filters CP1, CP2, and CP3 of FIG. 5, respectively. However, the first, second, and third color filters CP1a, CP2, and CP3 may have different shapes compared to the first, second, and third color filters CP1, CP2, and CP3 of FIG. 5.

The first color filter CP1a may selectively transmit a light emitted from a first light emitting element ED1. The first color filter CP1 may be provided with a color filter opening OP_CP defined therethrough. A second sub-pattern SP2a may be disposed in the color filter opening OP_CP.

The second sub-pattern SP2a and the second color filter CP2 may include the same material and may be formed through the same process. The second sub-pattern SP2a may be disposed in a first light emitting area PXA-B. The second sub-pattern SP2a may overlap the first light emitting element ED1 in a plan view.

The third sub-pattern SP3 and the third color filter CP3 may include the same material and may be formed through the same process. The third sub-pattern SP3 may be disposed in the first light emitting area PXA-B. The third sub-pattern SP3 may overlap the first light emitting element ED1 in a plan view. The third sub-pattern SP3 may be disposed on the second sub-pattern SP2a.

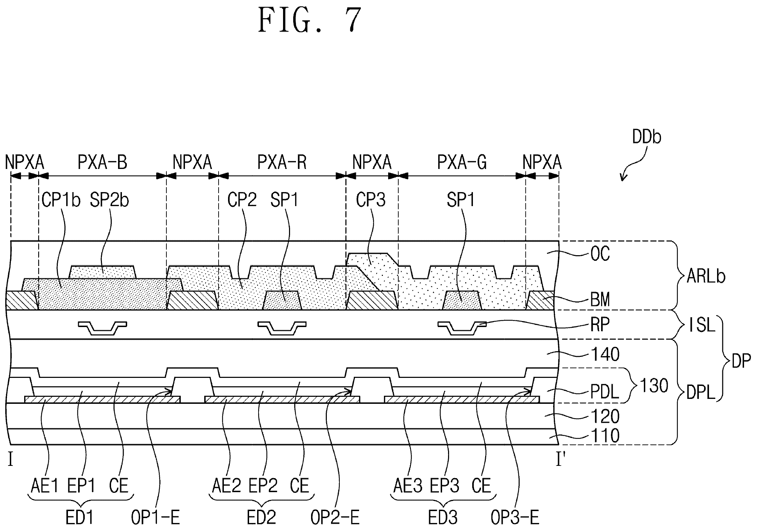

FIG. 7 is a schematic cross-sectional view of a display device DDb taken along line I-I' of FIG. 4. In FIG. 7, the same reference numerals denote the same elements in FIG. 5, and thus, detailed descriptions of the same elements will be omitted for descriptive convenience. For the convenience of explanation, FIG. 7 illustrates the display device DDb from which the window WM (refer to FIG. 2) is omitted.

Referring to FIG. 7, the display device DDb may include a display panel DP and an anti-reflective layer ARLb. The anti-reflective layer ARLb may include a light blocking pattern BM, first, second, and third color filters CP1b, CP2, and CP3, first and second sub-patterns SP1 and SP2b, and an overcoat layer OC.

The first, second, and third color filters CP1b, CP2, and CP3 may include the same material and may have the same function as the first, second, and third color filters CP1, CP2, and CP3 of FIG. 5, respectively. However, the first, second, and third color filters CP1b, CP2, and CP3 may have different shapes compared to the first, second, and third color filters CP1, CP2, and CP3 of FIG. 5.

The first color filter CP1b may selectively transmit a light emitted from a first light emitting element ED1. The first color filter CP1b may have a flat upper surface. As an example, the color filter opening OP_CP (refer to FIG. 6) may not be defined (or formed) through the first color filter CP1b, and a step difference may not be formed.

A second sub-pattern SP2b and the second color filter CP2 may include the same material and may be formed through the same process. The second sub-pattern SP2b may be disposed in a first light emitting area PXA-B. The second sub-pattern SP2b may overlap the first light emitting element ED1 in a plan view. The second sub-pattern SP2b may be disposed on the flat upper surface of the first color filter CP1b.

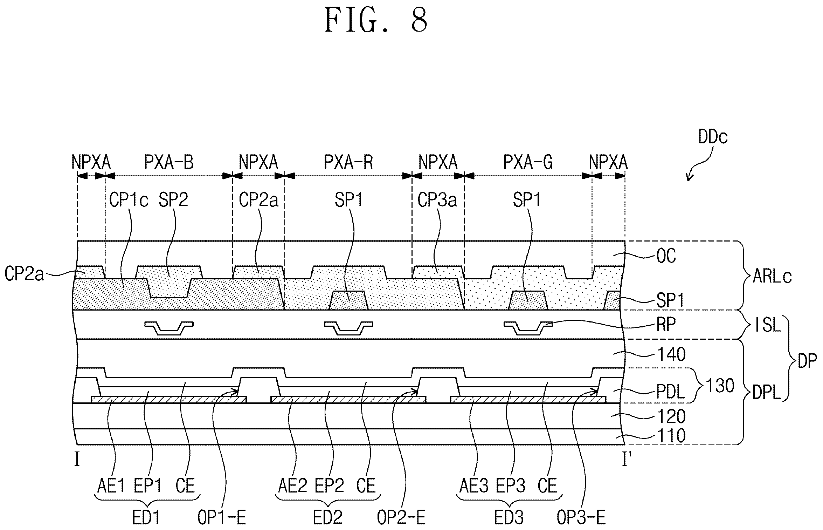

FIG. 8 is a schematic cross-sectional view of a display device DDc taken along line I-I' of FIG. 4. In FIG. 8, the same reference numerals denote the same elements in FIG. 5, and thus, detailed descriptions of the same elements will be omitted for descriptive convenience. For the convenience of explanation, FIG. 8 illustrates the display device DDc from which the window WM (refer to FIG. 2) is omitted.

Referring to FIG. 8, the display device DDc may include a display panel DP and an anti-reflective layer ARLc. The anti-reflective layer ARLc may include first, second, and third color filters CP1c, CP2a, and CP3a, first and second sub-patterns SP1 and SP2, and an overcoat layer OC. The anti-reflective layer ARLc of FIG. 8 may not include the light blocking pattern BM (refer to FIG. 5).

The first, second, and third color filters CP1c, CP2a, and CP3a may include the same material and may be formed through the same process as the first, second, and third color filters CP1, CP2, and CP3 of FIG. 5, respectively. However, the first, second, and third color filters CP1c, CP2a, and CP3a may have different shapes compared to the first, second, and third color filters CP1, CP2, and CP3 of FIG. 5.

The first color filter CP1c may be disposed to selectively transmit a portion of a light emitted from a first light emitting element ED1. The first color filter CP1c may include a first portion (refer to P1 of FIG. 5) having a first height (refer to H1 of FIG. 5) and a second portion (refer to P2 of FIG. 5) having a second height (refer to H2 of FIG. 5) smaller than the first height H1. The step difference of the first color filter CP1c may be formed using a halftone mask, however, this is an example, and embodiments are not limited thereto or thereby.

The second color filter CP2a may be disposed to selectively transmit a portion of a light emitted from a second light emitting element ED2. The third color filter CP3a may be disposed to selectively transmit a portion of a light emitted from a third light emitting element ED3.

An area where two or more color filters among the first, second, and third color filters CP1c, CP2a, and CP3a overlap each other may be defined as a light blocking area NPXA. According to an embodiment, a light may be blocked by overlapping multiple color filters CP1c, CP2a, and CP3a instead of using the light blocking pattern BM. As an example, the first color filter CP1c may overlap the second color filters CP2a adjacent thereto to define the light blocking area NPXA, the second color filter CP2a may overlap the first and third color filters CP1c and CP3a adjacent thereto to define the light blocking area NPXA, and the third color filter CP3a may overlap the first sub-pattern SP1 adjacent thereto to define the light blocking area NPXA. However, this is an example, and the overlapping of the color filters to define the light blocking area NPXA should not be limited thereto or thereby.

Referring to FIGS. 5 to 8, the areas where the first color filter CP1, CP1a, CP1b, or CP1c overlaps the second and/or third sub-patterns SP2 and SP3 and the area where the second and/or third color filter CP2 or CP2a and CP3 or CP3a overlap the first sub-pattern SP1 may be defined as the low transmission area or the light blocking area. The low transmission area or the light blocking area may absorb the external light. Accordingly, the display device DD, which includes the first, second, or third sub-patterns SP1, SP2, or SP3 overlapping the first, second, and third color filters CP1, CP2, and CP3, may exhibit reduced external light reflectance and improved reflective color tone in the first, second, and third light emitting areas PXA-B, PXA-R, and PXA-G. Thus, a display quality of the display device DD may be improved.

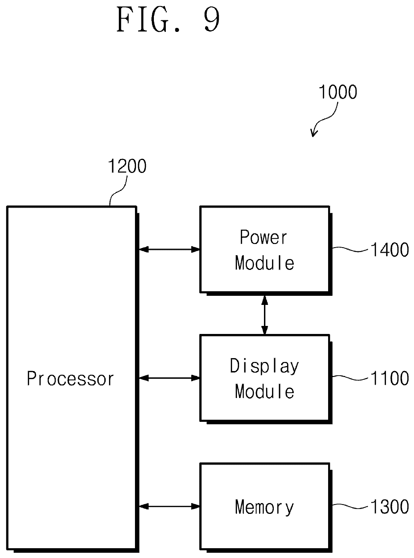

FIG. 9 is a block diagram of an electronic device according to an embodiment.

Referring to FIG. 9, an electronic device 1000 may include the display device DD (see FIG. 1) and output various information through a display module 1100 in an operating system. In case that a processor 1200 executes an application stored in a memory 1300, the display module 1100 may provide application information to a user through the display panel DP (see FIG. 3).

The electronic device 1000 may include a computing system providing an image display function, such as a smart watch, a mobile phone, a smart phone, a portable computer, a tablet personal computer (PC), a watch phone, an automotive display, smart glasses, a portable multimedia player (PMP), a navigation device, and an ultra mobile personal computer (UMPC). The electronic device 1000 may include at least one of a head mounted display (HMD) device, a virtual reality (VR) device, a mixed reality (MR) device, and an augmented reality (AR) device.

In concluding the detailed description, those skilled in the art will appreciate that many variations and modifications may be made to the embodiments without substantially departing from the principles of the invention. Therefore, the disclosed embodiments are used in a generic and descriptive sense only and not for purposes of limitation.

## Claims

1. A display device (DD) comprising:
a display layer (DPL) comprising:
a first light emitting element (ED1) that emits a first color light,
a second light emitting element (ED2) that emits a second color light different from the first color light, and
a third light emitting element (ED3) that emits a third color light different from the first and second color lights;
an input sensor layer (ISL) disposed on the display layer (DPL) and comprising a reflective pattern (RP); and
an anti-reflective layer (ARL) disposed on the input sensor layer (ISL), the anti-reflective layer (ARL) comprising:
a light blocking pattern (BM) including:
a first opening (OP1) overlapping the first light emitting element (ED1),
a second opening (OP2) overlapping the second light emitting element (ED2), and
a third opening (OP3) overlapping the third light emitting element (ED3);
a first color filter (CP1) overlapping the first opening (OP1);
a second color filter (CP2) overlapping the second opening (OP2);
a third color filter (CP3) overlapping the third opening (OP3);
a first sub-pattern (SP1) overlapping a portion of the second color filter (CP2) and a portion of the third color filter (CP3), the first sub-pattern (SP1) and the first color filter (CP1) comprising a same material;
a second sub-pattern (SP2) overlapping the first light emitting element (ED1) in a plan view, the second sub-pattern (SP2) and the second color filter (CP2) comprising a same material; and
an overcoat layer (OC) covering the first, second, and third color filters (CP1, CP2, CP3) and the second sub-pattern (SP2).

2. The display device (DD) of claim 1, wherein the first sub-pattern (SP1) is covered by the second color filter (CP2) and/or the third color filter (CP3).

3. The display device (DD) of claim 1 or 2, wherein
the first color filter (CP1) transmits a blue light,
the second color filter (CP2) transmits a red light, and
the third color filter (CP3) transmits a green light.

4. The display device (DD) of at least one of claims 1 to 3, wherein the light blocking pattern (BM) comprises a black coloring agent that absorbs a light.

5. The display device (DD) of at least one of claims 1 to 4, wherein an area where the light blocking pattern (BM) is disposed is defined as a light blocking area (NPXA) through which a light does not transmit.

6. The display device (DD) of at least one of claims 1 to 5, wherein an area where the first sub-pattern (SP1) or the second sub-pattern (SP2) is disposed transmits less light than an area where one of the first, second, and third color filter (CP1, CP2, CP3) is disposed.

7. The display device (DD) of at least one of claims 1 to 6, wherein an area where two or more color filters of the first, second, and third color filters (CP1c, CP2a, CP3a) overlap each other is defined as a light blocking area (NPXA).

8. A display device (DD) comprising:
a display layer (DPL) comprising:
a first light emitting element (ED1) that emits a first color light,
a second light emitting element (ED2) that emits a second color light different from the first color light, and
a third light emitting element (ED3) that emits a third color light different from the first and second color lights; and
an anti-reflective layer (ARL) disposed on the display layer (DPL), the anti-reflective layer (ARL) comprising:
a light blocking pattern (BM) defining a light blocking area (NPXA) through which a light does not transmit;
a first color filter (CP1) overlapping the first light emitting element (ED1) and transmitting a blue light;
a second color filter (CP2) overlapping the second light emitting element (ED2) and transmitting a red light; and
a third color filter (CP3) overlapping the third light emitting element (ED3) and transmitting a green light, wherein
a portion of the light blocking pattern (BM) adjacent to the first color filter (CP1) defines a first light emitting area (PXA-B),
a portion of the light blocking pattern (BM) adjacent to the second color filter (CP2) defines a second light emitting area (PXA-R),
a portion of the light blocking pattern (BM) adjacent to the third color filter (CP3) defines a third light emitting area (PXA-G), and
each of the first, second, and third light emitting areas (PXA-B, PXA-R, PXA-G) comprises a low transmission area (LTA) and a high transmission area (HTA).

9. The display device (DD) of claim 8, wherein the anti-reflective layer (ARL) comprises:
a first sub-pattern (SP1) overlapping a portion of the second light emitting area (PXA-R) and a portion of the third light emitting area (PXA-G), the first sub-pattern (SP1) and the first color filter (CP1) comprising a same material; and
a second sub-pattern (SP2) overlapping a portion of the first light emitting area (PXA-B) in a plan view, the second sub-pattern (SP2) and the second color filter (CP2) comprising a same material.

10. The display device (DD) of claim 9, wherein an area where the first sub-pattern (SP1) overlaps the portion of the second light emitting area (PXA-R) and the portion of the third light emitting area (PXA-G) and an area where the second sub-pattern (SP2) overlaps the portion of the first light emitting area (PXA-B) are defined as the low transmission area (LTA).

11. The display device (DD) of claim 9 or 10, wherein an area in the first, second, and third light emitting areas (PXA-B, PXA-R, PXA-G) where one of the first, second, and third color filter (CP1, CP2, CP3) is disposed without overlapping the first sub-pattern (SP1) and the second sub-pattern (SP2) is defined as the high transmission area (HTA).

12. The display device (DD) of at least one of claims 1 to 7 or one of claims 9 to 11, wherein an area where the first sub-pattern (SP1) or the second sub-pattern (SP2) is disposed absorbs an external light.

13. The display device (DD) of at least one of claims 1 to 12, wherein
the input sensor layer (ISL) comprises a conductive layer (200-CL1, 200-CL2) and an insulating layer (200-IL2, 200-IL3) covering the conductive layer (200-CL1, 200-CL2),
the reflective pattern (RP) is electrically insulated from the conductive layer (200-CL1, 200-CL2), and
the reflective pattern (RP) and the conductive layer (200-CL1, 200-CL2) comprise a same material.

14. The display device (DD) of at least one of claims 1 to 13, wherein
the first color filter (CP1) comprises a first portion (P1) having a first height (H1) and a second portion (P2) having a second height (H2) smaller than the first height (H1), and
the second sub-pattern (SP2) overlaps the second portion (P2) of the first color filter (CP1).

15. The display device (DD) of at least one of claims 1 to 7 or at least one of claims 9 to 14, wherein the second sub-pattern (SP2, SP2b) is disposed on the first color filter (CP1, CP1b).

16. The display device (DD) of at least one of claims 1 to 7 or at least one of claims 9 to 14, wherein
the first color filter (CP1) includes a color filter opening (OP_CP), and
the second sub-pattern (SP2) is disposed in the color filter opening (OP_CP).

17. The display device (DD) of at least one of claims 1 to 7 or at least one of claims 9 to 16, wherein
the anti-reflective layer (ARL) further comprises a third sub-pattern (SP3) disposed on the second sub-pattern (SP2a), and
the third sub-pattern (SP3) and the third color filter (CP3) comprise a same material.

18. An electronic device (1000) for providing an image comprising:
a display device (DD) according to at least one of claims 1 to 17.
